# EUROPEAN PATENT SPECIFICATION

(11) **EP 0 463 640 B1**
(45) Date of publication and mention of the grant of the patent: **03.04.1996**
(21) Application number: 91114289.1
(22) Date of filing: 30.07.1986
(51) Int. Cl.: G11C 8/00, G11C 19/00

(54) **Memory device for simulating a shift register**
Speicheranordnung zur Simulation eines Schieberegisters
Dispositif de mémoire pour simuler un régistre à déclage

(30) Priority: 30.07.1985 JP 168027/85
(43) Date of publication of application: 02.01.1992
(62) Divisional of application: 86110494.1
(73) Proprietor: KABUSHIKI KAISHA TOSHIBA, Kawasaki-shi, Kanagawa-ken 210, Tokyo (JP)
(72) Inventor: Sumi, Masahiko, Chigasaki-shi, Kanagawa-ken (JP)
(74) Representative: Lehn, Werner, Dipl.-Ing.

(56) References cited:
- WO-A-85/02935
- US-A- 4 395 764
- US-A- 4 509 142

## Description

### BACKGROUND OF THE INVENTION

The present invention relates to a memory device. Shift registers comprising a plurality of registers cascade-connected to shift their contents in sequence play an important role in computational processings or image processings, etc. Products having various capacities of 4, 8, 16, 1024 and 64K bits, etc. have been available.

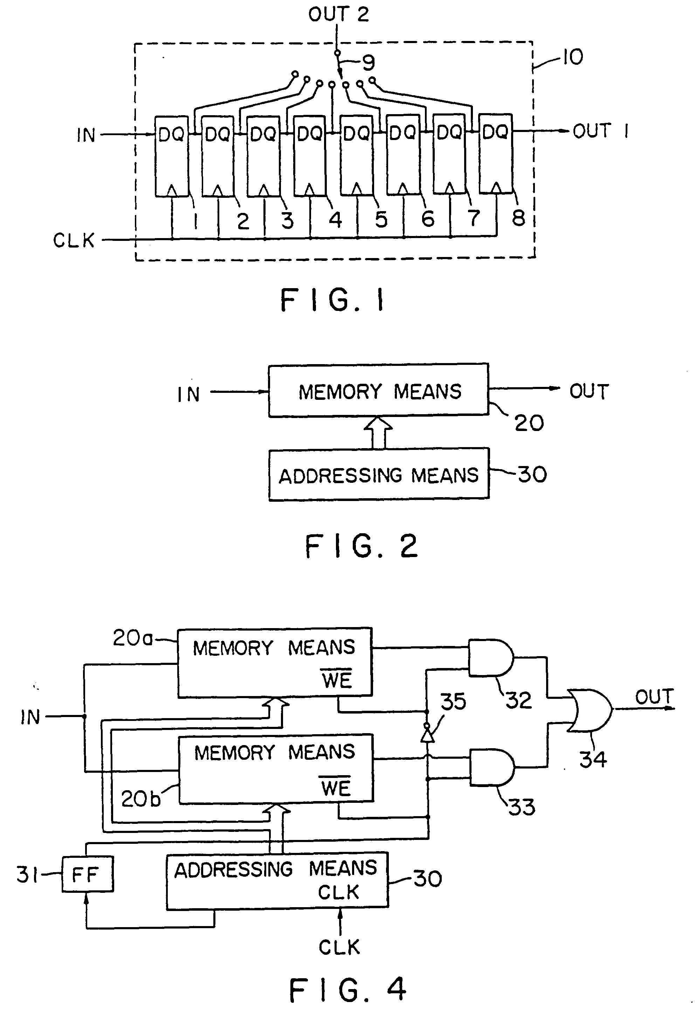

Referring to Fig. 1, there is shown an example of a commonly used conventional shift register 10 of 8 bit configuration. This shift register 10 comprises eight stages of flip-flops 1 to 8 wherein Q outputs of the flip-flops are respectively connected to D inputs of the next stages thereof and a clock line is commonly connected to the respective flip-flops.

With the shift register thus configured, when a clock pulse signal is input from the clock line CLK, data input to the leftmost flip-flop 1 is transferred to the right per each clock pulse and output data is fetched from an output terminal OUT 1 of the rightmost flip-flop 8.

To change the number of stages in the shift register 10 of the eight stages, as shown in Fig. 1, a method has been employed to provide lead-out or draw-out lines on the output sides of the respective stages of the flip-flops to switch the lead-out lines by using a changeover switch 9 to fetch an output delivered through the selected lead-out line from an output terminal OUT 2 to the external.

When the shift register has a small number of stages as in the above-mentioned example, this method is satisfactory, but when the shift register has a large number of stages, its realization is impossible in an actual sense.

For instance, when characters or figures (graphic pattern) are displayed on a CRT using a display device, there is employed a method to store display information in a storage unit to use the information read for a required display. When there is no change in information corresponding to one frame (frame information), it is convenient to repeatedly read the display information at a rate of 60 per second. Generally, a volume of such an information corresponding to one frame is not necessarily expressed by the second power (power of 2) and the frame information requires a large capacity. Hitherto, for storing such a frame information, it was necessary to specially provide a storage unit having a required memory capacity, resulting in high cost of the device. In addition, in the case of the above-mentioned example, since all of the memory capacity of the second power are not used, there occurs a wasteful memory capacity and an operation for combining valid or effective informations with each other is required.

US-A- 4 395 764 discloses a memory according to the preamble of Claim 1. In a RAM used as a variable length shift register the X- and Y- decoders are substituted by shift registers in which a single "1" is shifted for activating word and bit lines so that memory cells are addressed sequentially. Thus, the RAM behaves at its input/output like a conventional shift register. By controlling the number of shifts in the X and Y shift registers, the RAM can simulate shift registers of variable lengths. For simulating a shift register having its output connected to the input (ring shift), the RAM is read without writing new data whereas it is operated in read-modify-write mode for emulating normal shift operation. No hardware feedback exists between memory output and input.

WO85/02935 discloses a RAM/presettable counter combination used as a shift register.

An object of the present invention is to provide a memory device having an arbitrary number of stages.

Another object of the present invention is to provide a memory device having an arbitrary number of stages and capable of outputting the same value every a single-cyclic clock signal.

A further object of the present invention is to provide a memory device having an arbitrary number of stages and capable of changing memory contents according to need.

A still further object of the present invention is to provide a memory device having an arbitrary depth of 2N stages using a double-cyclic N clock signal.

According to the invention, there is provided a memory device as defined in Claim 1.

Preferably a shift register is provided to designate said preset value of the presettable counter.

In the accompanying drawings:
Fig. 1 is a schematic view illustrating a conventional shift register;
Fig. 2 is a block diagram showing a basic concept of a memory device for use in explaining a memory device according to the present invention;
Fig. 3 is a circuit diagram illustrating an embodiment of the memory device based on the configuration shown in Fig. 2;
Fig. 4 is a circuit diagram illustrating a modified embodiment based on the configuration shown in Fig. 2;
Fig. 5 is a block diagram showing the concept of a memory device according to the present invention wherein the memory device has a function to repeatedly read the same data;
Fig. 6 is a circuit diagram illustrating an embodiment of the memory device based on the configuration shown in Fig. 5; and
Fig. 7 is a timing chart showing the operation of the memory device shown in Fig. 6.

### DETAILED DESCRIPTION OF THE INVENTION

The present invention will be described in detail in connection with preferred embodiments with reference to attached drawings.

Initially, referring to Fig. 2, there is shown, in a block form, a basic concept of a memory device for use in explaining the present invention. The memory device shown is configured so that addresses of a memory means 20 for storing input data therein are designated by an addressing means 30, thus effecting write and read operations of data. This addressing means 30 has a function to cyclically designate addresses of the memory means 20 so that the same value of the address is not designated during one cycle. For instance, when the number of the designation is equal to N, the addressing means 30 functions as an mod-N counter (defined as a counter having N states in the positional notation) which is decremented by one from N-1 per each clock pulse to return to the value of N-1 for a second time when the count value is equal to zero. The memory means 20 has a function to store data into a memory area assigned to an address designated by the addressing means 30 and/or read the data therefrom. For the memory means 20, e.g., dynamic RAM of 64K bit configuration may be used.

The memory device thus configured operates as follows. First, an address is designated by using the addressing means 30 to store data into a memory area assigned to the designated address. In the next step, by allowing the addressing means 30 to circulate so as to designate the same address in the same order, data is read from the concerned memory area, thus making it possible to fetch the same data previously stored therefrom. Thus, the memory device functions as a shift register.

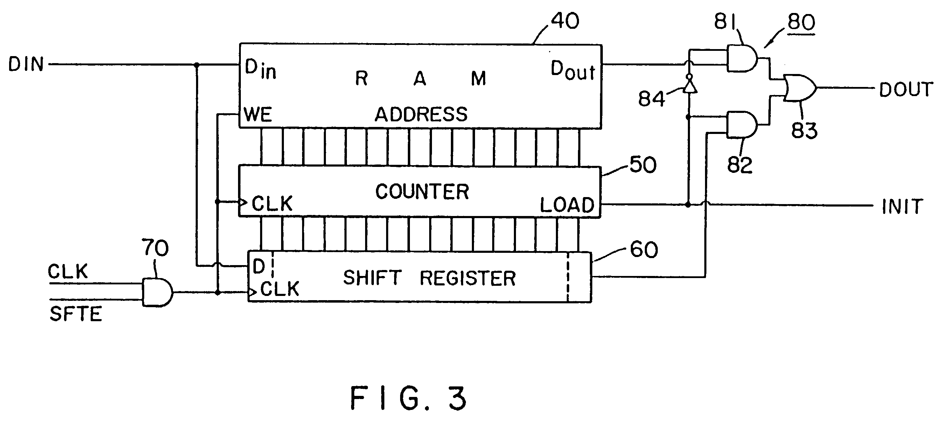

Fig. 3 is a circuit diagram illustrating an embodiment based on the configuration shown in Fig. 2. This memory device comprises a RAM 40, a counter 50 for designating write and read addresses of the RAM 40 one by one per each clock pulse, a shift register 60 for setting a count value to the counter, a control circuit 70 for effecting control of the entirety of the memory circuit, and a selector 80.

In this embodiment, the RAM 40 is comprised of a dynamic RAM of 64K bit configuration. The RAM 40 is provided with 16 address lines, thus making it possible to write data into a memory area assigned to an address determined by the selection of the address lines or read it from the memory area assigned to the address. To perform this function, the RAM 40 is provided with a write enable (WE) terminal, a data input (Dᵢₙ) terminal and a data output (Dₒᵤₜ) terminal.

The counter 50 counts down one by one per each clock pulse from a designated value less than (2¹⁶-1). After the count value reaches zero, the counter 50 repeatedly counts down from the value of n. In this counter 50, the value of n is determined by 16 set inputs.

The shift register 60 is configured as a sixteen stage shift register for setting the value of n wherein outputs of their staaes are set inputs of the counter. respectively.

The control circuit 70 is comprised of an AND gate to which a clock (CLK) signal and shift enable (SFTE) signal are input. An output of the control circuit 70 is input to a CLK terminal of the shift register 60, a CLK terminal of the counter 50 and a WE (write enable) terminal of the RAM 40. When the SFTE signal is at high level, the CLK signal is delivered to the above-mentioned circuit components from the control circuit 70.

The selector 80 comprises an AND gate 81 to which a Dₒᵤₜ output of the RAM 40 and a signal obtained by inverting an initialization (INIT) signal using an inverter 84 are input, an AND gate 82 to which the INIT signal and an output of the shift register 60 are input, and an OR gate to which outputs from the two AND gates are input. An output of the OR gate 83 is output as an output of the entire circuit. The INIT signal is also input to a LOAD terminal of the counter 50.

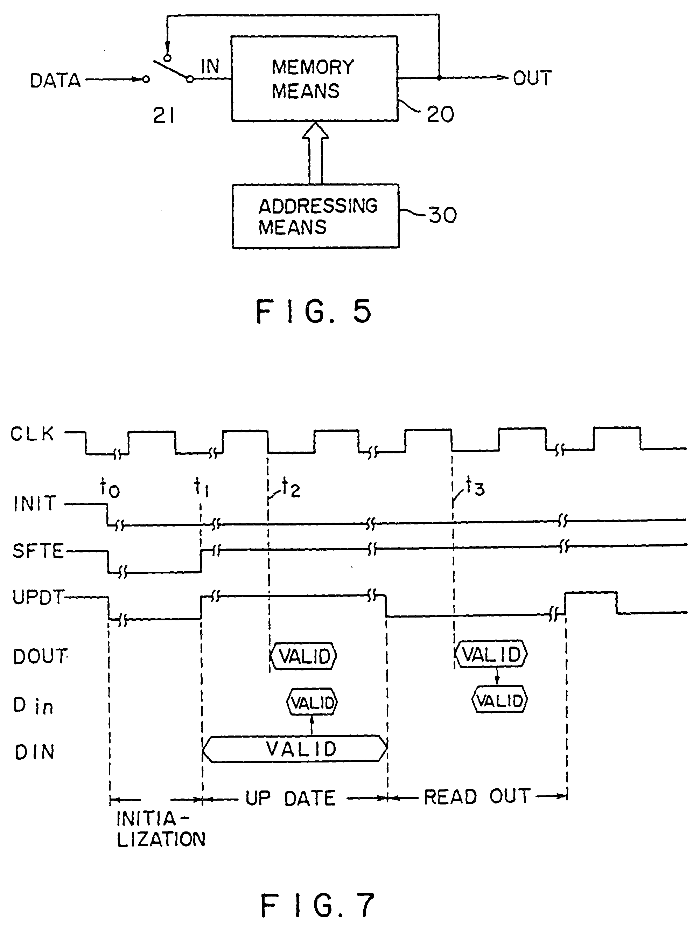

Fig. 4 is circuit diagram illustrating another modification of the configuration shown in Fig. 2.

In this embodiment, the memory device comprises two memory means 20a and 20b subject to addressing by a common addressing means represented by the same reference numeral 30 as in the circuit shown in Fig. 2. The memory device further comprises a flip-flop 31 which inverts its state when a designated value becomes zero in response to the completion of a single-cyclic clock signal. An output signal of the flip-flop 31 is delivered to a write enable (WE) terminal of the memory means 20a through an inverter 35 and is directly delivered to a write enable (WE) terminal of the memory means 20b so that signals delivered to the WE terminals of the memory means 20a and 20b are opposite to each other in their logical states. To the memory means 20a and 20b, data is commonly input. An output of the memory means 20a and an inverted signal of the output signal from the flip-flop 31 are input to an AND gate 32. An output of the memory means 20b and the output signal from the flip-flop 31 are input to an AND gate 33. Two outputs of the AND gates 32 and 33 are input to an OR gate 34. Thus, output data is output from memory means placed in the write-disabled state in accordance with the function given by the circuit comprising the inverter 35, the AND gates 32 and 33 and the OR gate 34.

The operation of the embodiment shown in Fig. 4 will be described below.

Assuming now that the output of the flip-flop 31 represents logical "1" in an initial state, the memory means 20b is in write-disabled state and the memory means 20a is in write enabled state. When an address is designated by the addressing means 30, data is read from the memory means 20b one by one per each clock pulse and the data thus read is output through the AND gate 33 and the OR gate 34. At this time, data is written into a memory area assigned to a designated address of the memory means 20a. The output of the memory means 20a is disallowed because the AND gate 32 is in disable state.

Subsequently, when the address designation value is successively decremented and then reaches to zero, the address designation value becomes equal to N-1 for a second time and at the same time an output of the flip-flop 31 is inverted so that its logical state becomes "0". As a result, data is read from the memory means 20a and data is written into the memory means 20b.

This embodiment can eliminate the possibility of discontinuity of data which would occur in the embodiment shown in Fig. 2 and realize substantially the same memory device as a 2N state shift register.

Referring to Fig. 5, there is shown an embodiment of a memory device according to the present invention wherein memory means represented by reference numeral 20' and the addressing means 30 are provided in the same manner as in the configuration shown in Fig. 2. In this embodiment, the addressing means 30 is basically identical to that in the configuration shown in Fig. 2, but the memory means 20' differs from that in the latter in that it has a function to write data while reading it, i.e., effect so-called read modify write operation. An output of the memory means 20' is fetched therefrom and at the same time the output is fed back to the input side of the memory means 20' to again input the output thus fed back to the memory means through a switch means 21. The switch means 21 may be comprised of e.g. a gate circuit for selecting a new data input or a re-input of memory contents.

In the memory device thus configured, by allowing the addressing means 30 to cyclically designate the same value in the same order during each cycle and by setting the switch means 21 so as to rewrite an output of the memory means 20', it is possible to repeatedly fetch a series of the same data per each cycle. Further, by changing the number of addresses assigned to memory areas in the memory means 20' designated by the addressing means 30, the memory device in this embodiment can function as a shift register having an arbitrary number of stages. In addition, when the switch means 21 is set to the DATA input, the memory device in this embodiment has substantially the same configuration and operation as in the device shown in Fig. 1.

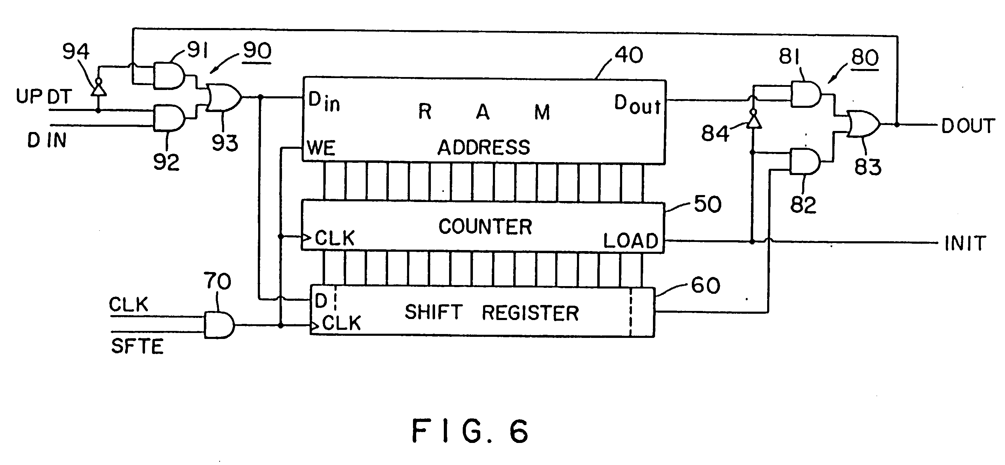

Fig. 6 is a circuit diagram illustrating more detail of the configuration shown in Fig. 5.

This memory device shown is provided, as the same circuit components as those in the circuit shown in Fig. 3, with the RAM 40, the counter 50 for designating write and read addresses of the RAM 40 one by one per each clock pulse, the shift register 60 for setting a count value to the counter 50, the control circuit 70 for effecting the entirety of the circuit, and the selector 80, and it is provided with a selector 90 newly added in this embodiment.

The configuration and the operation of the RAM 40, the shift register 60, the control circuit 70 and the selector 80 have been previously described in connection with the embodiment shown in Fig. 3. Therefore, their explanation will be omitted and the configuration and the operation of the selector 90 will now be mainly referred to here.

The selector 90 comprises an AND gate 92 to which an update (UPDT) signal and an entire circuit input Dᵢₙ are input, an AND gate 91 to which a signal obtained by inverting the UPDT signal using an inverter 90 and an output of the selector 80 are input, and an OR gate 93 to which outputs from the two AND gates are input. An output of the OR gate 93 is input to an input Dᵢₙ of the RAM 40 and a D terminal of the shift register 60.

The operation of the memory device thus configured will be described with reference to a timing chart shown in Fig. 7.

First, the UPDT signal is set at H level to input store data into the shift register 60, i.e. data indicative of a count start number n. At this time, a SFTE signal of H level is input to the control circuit 60 to input 16 clock pulses so that the data indicative of the count start number is stored into the shift register 60. Thus, the counter start number n is stored into the shift register 60 in a binary form. Accordingly, when an INIT signal of H level is input to the LOAD terminal of the counter 50, the count start number n is set to the counter 50. Then, when the INIT signal shifts to L level, the data indicative of the count start number n is maintained in the counter 50 as it is. The initialization is thus completed. Accordingly, when the INIT signal and the SFTE signal are respectively set at L level at time t₀, the initialized condition is maintained.

Then, for allowing this memory device to function as a device identical to ordinary shift registers, this memory device operates so as to output SFTE signal of H level from the control unit 70 and to output UPDT signal of H level from the selector 90 (time t₁ in Fig. 7). As a result, the DIN input becomes valid because an output of the AND gate 92 shifts to H level. In this embodiment, the RAM 40 effects the read modify write operation as previously described. Accordingly, the data read output Dₒᵤₜ becomes valid at the time of a falling of the CLK signal at time t₂ in Figl. 7, with the result that the write input Dᵢₙ becomes valid within a portion of the valid period of the data read output. Accordingly, when data of N bits to be stored as the Dᵢₙ signal is input, this N bit data is delivered to the Dᵢₙ input terminal of the RAM 40 via the AND gate 92 and the OR gate 93. At this time, since the SFTE signal is placed in H level, the CLK signal is input from the control circuit 70 to the CLK terminal of the counter 50 and the WE terminal of the RAM 40. Accordingly, data is written, bit by bit, into memory areas assigned to respective addresses of the RAM 40 corresponding to count values output from the counter 50. When the count value of the counter 50 is equal to zero, the count value represents n for a second time at timing of the next clock pulse. At this time, the contents stored in the RAM 40 ar e output as the data read output Dₒᵤₜ irrespective of the fact that any data is input as the DIN. Namely, for a time period during which a count value of the counter 50 circulates, data is fetched in order of storing data in the previous cycle. Thus, this memory device functions as an N (N = n+1) stage shift register which effects FIFO operation.

When data input to the DIN terminal at the time of reading is valid data, the content of the RAM 40 is replaced by this valid data and the valid data thus replaced is read in the next count cycle. In contrast, when the input data is invalid or null data, the content of the RAM 40 becomes invalid.

The operation for repeatedly reading the same data will now be described.

Initially, as previously described, the UPDT signal and the SFTE signal are set at H level to input valid data from the DIN terminal to store it into the RAM 40. When a count value of zero is reached, the UPDT signal is set at L level. Thus, an input to the AND gate 91 shifts to H level. As a result, the DOUT signal is input to the Dᵢₙ terminal. Accordingly, since the Dᵢₙ input becomes valid for a time period during which the DOUT output is valid as indicated by time t₃ in Fig. 7, it is possible to store the memory content of the RAM 40 into the RAM 40 for a second time. Thus, the same memory contents can be repeatedly fetched.

To realize such a memory device , it is sufficient to provide 8 pins for DIN, DOUT, CLK, SFTE, INIT, UPDT, power supply and ground. This memory device can be configured as e.g. a single-in-line package provided with lead wires for the above-mentioned terminals. In addition, this memory device has a circuit configuration such that a simple circuit e.g. a counter is only added to RAM. As a result, there is no possibility that an area for circuit components is increased, thus facilitating realization of integrated circuit.

In the above-described embodiments, the counter which successively counts down one by one per each clock pulse is used for the addressing means. Instead, there may be employed a counter to successively count up one by one or a counter which does not necessarily output continuous values, but outputs discrete different values during each cycle. The essential requirement for the addressing means is to have a function as state transition means capable of designating non-used write or read addresses of memory means without repeatedly addressing the same value during each cycle. In view of this, e.g. a random number generator which does not generate the same number may be used. When such a random number generator is employed, it is required to reconstruct read data on the basis of designated addresses.

In the above-mentioned embodiment, the shift register is used to set the number of stages required for the counter operation to the counter. According to use, there are instances where there is no need to change the depth as the memory device. In these instances, the number of stages required for the counter operation may be set by ROM. In addition, the shift register employed in the above-mentioned embodiment is of the serial setting type, but shift registers of the parallel setting type may be used.

Further, by connecting a plurality of circuits each employed in the above-mentioned embodiments in series, i.e., by connecting DOUT terminal to DIN terminal of the next stage circuit, it is possible to provide a large number of stages as desired.

In the above-mentioned embodiment, the counter has the same operation mode at the time of writing of data as that at the time of reading of data. Accordingly, each memory device including such a counter functions as a FIFO memory. In addition to this, if addressing at the time of reading is carried out in order opposite to that at the time of writing, each memory device can be used as a FILO memory. For this purpose, a reversible shift register may be used for the shift register.

As described in detail, the memory device is provided with memory means capable of storing data into a memory area assigned to an address designated or reading it therefrom, and addressing means for designating address values different from each other during each cycle. Accordingly, by selecting the number of address values designated by the addressing means, it is possible to provide a memory device having an arbitrary number of stages which has a capacity less than that of the memory means.

Further, by employing the memory means capable of effecting read and write operations at the same time to deliver its output back to the input side thereof for a second time, it is possible to provide a memory device having an arbitrary number of stages which is capable of repeatedly outputting the same data.

In addition, by employing two memory means having the common data input and the common addressing input, and the flip-flop which inverts its state in response to the completion of addressing singal corresponding to one cycle having N clock pulses from the addressing means to input an output of the flip-flop to the write enable terminals of the two memory means so that logical states at the write enable terminals are opposite to each other, it is possible to provide a 2N memory device having an arbitrary number of stages.

## Claims

1. A memory device comprising:
memory means (20) having a plurality of addresses;
addressing means (30) for repetitively generating address designating signals for designating the addresses of said memory means within said plurality of addresses according to a fixed sequence including a settable address during each operating cycle of said memory device;
said memory means being adapted to cyclically output data stored at different addresses corresponding to said fixed sequence of address designating signals, and at the same time, to cyclically write new data for a next cycle at the same addresses to said fixed sequence of address designating signals; characterised by
said addressing means comprising a presettable counter (50) for holding a preset value indicating said settable address;
switch means (21) operative in a first position for connecting an output of said memory means to an input of said memory means and in a second position for connecting said input of said memory means to an external data source;
said memory device being operative with said switch means in said first position for repetitively circulating the same data through said memory means at said different addresses corresponding to said fixed sequence of address designating signals; and
said memory device being operative with said switch means in said second position for passing data only once from said external data source through said different addresses corresponding to said fixed sequence of address designating signals and to said output of said memory means.

2. A memory device as set forth in claim 1, wherein said switch means is comprised of a gate circuit which operates in response to a switching signal.

3. A memory device as set forth in claim 1 or 2 wherein a shift register is provided to designate said preset value of the presettable counter.

## Patentansprüche

1. Speichervorrichtung, aufweisend:
- eine Speichereinrichtung (20), die eine Vielzahl von Adressen aufweist;
- eine Adressiereinrichtung (30) zum wiederholten Erzeugen von Adressenbezeichnungssignalen während jedes Betriebszyklus der Speichereinrichtung zum Kennzeichnen der Adressen der Speichereinrichtung innerhalb der Vielzahl von Adressen gemäß einer festen Sequenz, die eine einstellbare Adresse enthält;
- wobei die Speichereinrichtung angepaßt ist, um zyklisch Daten auszugeben, die bei verschiedenen Adressen entsprechend der festen Sequenz der Adressenbezeichnungssignale gespeichert sind, und um gleichzeitig zyklisch neue Daten für einen neuen Zyklus bei den gleichen Adressen entsprechend der festen Sequenz der Adressenbezeichnungssignale zu schreiben;
dadurch **gekennzeichnet**,
- daß die Adressiereinrichtung einen voreinstellbaren Zähler (50) zum Halten eines voreingestellten Wertes umfaßt, der die einstellbare Adresse anzeigt;
- daß sie eine Schalteinrichtung (21) umfaßt, die in einer ersten Position wirksam ist, um einen Ausgang der Speichereinrichtung an einen Eingang der Speichereinrichtung anzuschließen, und die in einer zweiten Position wirksam ist, um den genannten Eingang der Speichereinrichtung an eine äußere Datenquelle anzuschließen;
- daß die Speichervorrichtung bei in der ersten Position befindlicher Schalteinrichtung wirksam ist, um wiederholt die gleichen Daten durch die Speichereinrichtung an den unterschiedlichen Adressen entsprechend der festen Sequenz der Adressenbezeichnungssignale umlaufen zu lassen; und
- wobei die Speichervorrichtung bei in der zweiten Position befindlicher Schalteinrichtung betriebsbereit ist, um Daten nur ein einziges Mal von der äußeren Datenquelle durch die verschiedenen Adressen entsprechend der festen Sequenz der Adressenbezeichnungssignale zum Ausgang der Speichereinrichtungen laufen zu lassen.

2. Speichervorrichtung nach Anspruch 1, bei der die Schalteinrichtung aus einer Gatterschaltung besteht, die als Antwort auf Umschaltsignale arbeitet.

3. Speichervorrichtung nach Anspruch 1 oder 2, bei der ein Schieberegister vorgesehen ist, um den voreingestellten Wert des voreinstellbaren Zählers zu bezeichnen.

## Revendications

1. Un dispositif de mémoire qui comprend:
un moyen de mémoire (20) qui inclut une série d'adresses;
un moyen d'adressage (30) pour engendrer de façon répétitive des signaux désignant des adresses afin de désigner les adresses du moyen de mémoire à l'intérieur de ladite série d'adresses en fonction d'une séquence fixe qui inclut une adresse définissable pendant chaque cycle opératoire dudit dispositif de mémoire;
ledit moyen de mémoire étant apte à envoyer de façon cyclique des données mémorisées à différentes adresses correspondant ladite séquence fixe de signaux désignant des adresses et d'écrire en même temps, de façon cyclique, de nouvelles données pour un cycle suivant aux mêmes adresses à ladite séquence fixe de signaux désignant des adresses;
caractérisé en ce que
ledit moyen d'adressage comprend un compteur définissable au préalable (50) pour tenir une valeur prédéfinie qui indique ladite adresse définissable;
un moyen commutateur (21) peut être placé dans une première position pour connecter une sortie dudit moyen de mémoire à une entrée dudit moyen de mémoire et dans une deuxième position pour connecter ladite entrée dudit moyen de mémoire à une source de donnée externe;
ledit dispositif de mémoire peut fonctionner, quand ledit moyen de commutation est dans ladite première position, pour mettre en circulation de façon répétée la même donnée à travers ledit moyen de mémoire auxdites adresses différentes qui correspondent à ladite séquence fixe de signaux désignant des adresses; et
ledit dispositif de mémoire peut fonctionner, lorsque ledit moyen commutateur est dans ladite deuxième position, pour ne faire passer qu'une seule fois une donnée, qui provient de ladite source de donnée externe, à travers ledites adresses différentes qui correspondent à ladite séquence de signaux désignant des adresses et vers ladite sortie dudit moyen de mémoire.

2. Un dispositif de mémoire selon la revendication 1, dans lequel ledit moyen commutateur comprend un circuit de porte qui fonctionne en réponse à un signal de commutation.

3. Un dispositif de mémoire selon la revendication 1 ou 2 dans lequel un registre à décalage est prévu pour désigner ladite valeur prédéfinie dudit compteur définissable au préalable.
